(19) 

Europäisches
Patentamt
European
Patent Office
Office européen
des brevets

(11)     EP 2 814 172 A1

(12)                    EUROPEAN PATENT APPLICATION

(43) Date of publication:
     **17.12.2014   Bulletin 2014/51**

(51) Int Cl.:
     ***H03H 7/06*** (2006.01)

(21) Application number: **13290128.1**

(22) Date of filing: **10.06.2013**

(84) Designated Contracting States:
     **AL AT BE BG CH CY CZ DE DK EE ES FI FR GB
     GR HR HU IE IS IT LI LT LU LV MC MK MT NL NO
     PL PT RO RS SE SI SK SM TR**
     Designated Extension States:
     **BA ME**

(71) Applicant: **ALCATEL LUCENT
     92100 Boulogne-Billancourt (FR)**

(72) Inventors:
     • **Bulja, Senad
       Blanchardstown
       Dublin 15 (IE)**

     • **Rulikowski, Pawel K.
       Blanchardstown
       Dublin 15 (IE)**

(74) Representative: **Lupton, Frederick
     51 Bullens Green Lane
     Colney Heath
     St. Albans, Herts. AL4 0QR (GB)**

     Remarks:
     Amended claims in accordance with Rule 137(2)
     EPC.

(54)   **Filter for RF applications**

(57)   In order to provide very high attenuation between pass-band and stop-band in an RF filter assembly, which includes a first RF filter (14) for providing a filtered RF signal, an 3dB hybrid coupler (18) has an input port (1) connected to receive the filtered RF signal, and an output port (4) to provide a further filtered RF signal, the coupler including a third port (2, 3) connected to a reflective load (70, 86), the reflective load including first and second filter paths connected in parallel, the first path including a first reactive element (74) having a first predetermined reactance value (jX2) and a bandpass second filter (76), and the second path including a second reactive element (80) having a second predetermined reactance value (jX1) and a bandpass second filter (82). The first and second predetermined reactance values have equal and opposite values, such as to provide first and second transmission zeros at the same frequency within the stop band of the first RF filter, the stop bands of the bandpass filters occuring within the pass band of the first RF filter, such as to reflect the signal to the coupler output port (4).

Figure 7

## Description

Field of the Invention

The present invention relates to a filter employed in RF applications, particularly though not exclusively applications in mobile telecommunications systems.

Background Art

Filters are widely used in telecommunications applications, e.g. base stations, radar systems, amplifier linearization, point-to-point radio and RF signal cancellation. The choice of a filter is ultimately dependent on the application; however, there are certain desirable characteristics that are common to all filter realisations. For example, the amount of insertion loss in the pass-band of the filter should be as low as possible, while the attenuation in the stop-band should be as high as possible. Further, in some applications the frequency separation between the pass-band and stop-band (guard band) needs to be very small, which requires filters of high order to be deployed. However, the requirement for a high order filter is always followed by an increase in the cost and space, due to a greater number of components required. Even though increasing the order of the filter increases the attenuation in the stop-band, it inevitably increases the losses in the pass-band.

The requirement for high attenuation in the stop-band is driven by the ever tightening requirements for higher isolation between transmit and receive channels. As such, attention is focused on techniques that allow the insertion of a transmission zero (notch, or region in which there is essentially zero transmission through the filter) in the response of the filter for increasing attenuation in the stop-band of the filter and outside of the pass-band.

US-A-2011/0080856 discloses an RF duplexer having a filter for transmit signals coupled to an "analogue quadrature splitter", to which is connected first and second identical filter elements, the splitter and filter elements being adapted to increase an attenuation of out-of-band transmit signals.

European Patent Application EP12360054.6 filed 02.08.2012 (ref. 811079) discloses a filter assembly including a first RF filter having a first filter pass band and a first filter stop band, a hybrid coupler connected to receive the filtered RF signal and to provide a further filtered RF signal, a pair of filtered reflective loads being coupled with the hybrid coupler to respond to the filtered radio frequency signal, each filtered reflective load including a second filter having a second filter pass band which overlaps with the first filter stop band. Selecting the pass-band of the filtered reflective loads to overlap with the stop-band of the RF filter causes firstly the portion of the filtered signal within the pass-band of the filtered reflective load to be dissipated, which provides a deep and broad transmission zero close to the pass band of the first filter. Secondly the RF signal in the stop bands of the reflective loads is reflected back via the coupler to provide an output radio frequency signal. Since high power does not flow through the filtered reflective loads, consequently smaller and less robust components can be used for those filters, which reduces their size and cost.

Summary of the Invention

The present invention provides, in embodiments, an RF filter assembly including a first RF filter having a pass band and a stop band for providing a filtered RF signal. An RF reflective means is coupled to receive the filtered RF signal, and to provide a further filtered RF signal. This RF reflective means includes a reflective load, which performs a filtering action. For the purposes of the present specification, the term "reflective load" is to be understood as meaning a load designed to operate at a certain frequency or range of frequencies, but that outside that frequency or range of frequencies, mis-match occurs for incoming RF signals, which are consequently reflected away from the reflective load.

The RF reflective means also includes an RF connecting device to receive the filtered RF signal at an input port, and to provide a further filtered RF signal at an output port. The reflective load is coupled to a further port of the connecting device. The ports are interconnected within the connecting device by a mechanism relying on the wave properties of RF signals, such that for frequencies away from the operating frequencies of the reflective load, the signal at the input port is transmitted through to the output port, but that for frequencies within the operating frequencies, the input RF signal is absorbed (at least partially) by the reflective load.

The RF connecting device may take any one of a wide variety of forms, but, conveniently, in many embodiments, the device includes an RF coupler. As explained in more detail below, an RF coupler is usually a 4 port device, wherein one port is used as input, another port as output, and third and fourth ports are coupled to one or more reflective loads. Said filtered signal is received as an input, subjected to a further filtering action by the reflective load, and the further filtered signal is passed to the output port of the coupler.

In one embodiment, a reflective load includes first and second filter paths connected in parallel, the first path including a first reactive element, a bandpass second filter and a terminating load, and the second path including a second reactive element, a bandpass second filter and a terminating load, wherein the resultant impedances of the first and second paths are chosen to provide first and second transmission zeros at frequencies such that the pass bands of the bandpass filters occur in the stop band of the first RF filter, and the stop bands of the bandpass filters occur within the pass band of the first RF filter. In this way, as will be explained in more detail below, an overall deep and broad transmission zero may be provided in the overall filter assembly transfer characteristic, at a selected position relative to the pass band of the first RF filter.

Embodiments of the invention do not employ inverting impedances formed by quarter wave transmission line lengths, which at lower frequencies, may be physically too big for practical use, nor by their lumped circuit equivalents. Instead non-inverting reactive impedance elements are employed. The reactance values of the reactive elements in each path have predetermined values, and are selected in relation to each other, to provide a double transmission zero for the reflective load, as will be explained.

For convenience, each reactive element will comprise a single component, an inductor or a capacitor, since this provides a very physically compact and inexpensive arrangement, lending itself to miniaturization. However in some circumstances more than one component may be employed for convenience, e.g. two inductors or two capacitors, in order to give a single composite reactive value of inductance or capacitance, and which is a non-inverting impedance. Each reactive element may not have any significant value of resistance.

Any suitable RF connecting device may be employed in embodiments of the invention. RF connecting devices may take many and various forms, and go by many and various names, which names may not always be consistently applied throughout the industry. However connecting devices are commonly three or four port devices, wherein first and second ports may serve as input and output for an RF signal transmitted through the coupler, and the third or third and fourth ports provide auxiliary outputs responsive to the RF signal by means of an internal coupling which relies on the wave properties of RF signals.

Three port connecting devices include directional couplers and circulators. A circulator is a three terminal device that will normally allow an RF signal entering any port to be transmitted to only the next port in rotation. A circulator typically contains three transmission lines spaced 120 degrees apart, which are placed between two disks of ferrite material. In the present invention, first and third ports of a circulator may provide input and output, and the reflective load may be coupled to the second port.

Four port connecting devices include directional couplers, branch-line couplers (including 3 dB 90° hybrid couplers or quadrature couplers), Lange couplers, hybrid ring couplers. In terms of internal construction, a directional coupler has a conductive path between ports 1 and 2, and a conductive path between ports 3 and 4, with an RF coupling between the two paths. A Lange coupler includes interdigitated fingers, with RF couplings between the fingers. Branch line couplers such as 3 dB 90° hybrid couplers are based on a rectangular configuration of quarter wave transmission line lengths, each length having a respective characteristic impedance value. Two equal amplitude outputs are provided at ports 2 and 3 for an input at port 1, which are relatively phase shifted by 90°, and port 4 is termed an isolated port.

90° hybrid couplers are particularly preferred for use firstly in view of their low cost, and secondly they may be used in a configuration where port 1 is input port, port 4 is output port, and ports 2 and 3 provide outputs, shifted by 90° to each other. Identical reflective loads may be connected to each of ports 2 and 3, each reflective load including a bandpass filter, with the signal reflected from the load being transmitted to the output port 4. As explained below, in embodiments of the invention, each reflective load may be constructed with two bandpass filters in parallel, such as to provide two transmission zeros at the same centre frequency. Thus the components of the signal at ports 2 and 3 will be subject to a deeper overall attenuation with steeper attenuation edges. The reflected components from ports 2 and 3 are recombined in the RF coupler at the output port 4, so that the output signal exhibits the "double" transmission zero. In other embodiments, the transmission zeros provided by each reflective load may be different in frequency.

The values of the terminating impedances will commonly be chosen to provide an overall resistive value for absorbing input signals; in some cases the impedance may be very low, effectively an earth connection.

Accordingly, embodiments of the invention provide an RF filter assembly including a first RF filter having a pass band and a stop band for providing a filtered RF signal, an RF reflective load means including an RF connecting device having a first input port connected to receive the filtered RF signal, a second output port to provide a further filtered RF signal, and including a third port with a reflective load connected to the third port, said reflective load including first and second series paths connected in parallel, the first series path including a first reactive element having a first predetermined reactance value, and a second filter, and the second series path including a second reactive element having a second predetermined reactance value, and a second filter, wherein said first and second predetermined reactance values have a relationship such as to provide first and second transmission zeros at frequencies such that pass bands of said second filters occur in the stop band of the first RF filter, and stop bands of said second filters occur within the pass band of the first RF filter.

Brief Description of the Drawings

An embodiment of the invention will now be described, by way of example only, with reference to the accompanying drawings, wherein:

Figure 1 is a circuit diagram of an RF filter described in European Patent Application EP12360054.6 filed 02.08.2012 (ref. 811079) referenced above;

Figures 2, 3 and 4 are graphs of responses of filters within the circuit of Figure 1;

Figures 5 and 6 are circuit diagrams of further RF filters described in European Patent Application EP12360054.6 filed 02.08.2012 (ref. 811079);

Figure 7 is a circuit diagram of a RF filter, according to an embodiment of the invention;

Figure 8 is a circuit schematic of a reflective load within the circuit of Figure 7;

Figure 9 is a graph of responses of filters within the circuit of Figure 7; and

Figure 10 is a graph illustrating improvement in stop-band attenuation in the circuit of Figure 7.

Description of an Embodiment

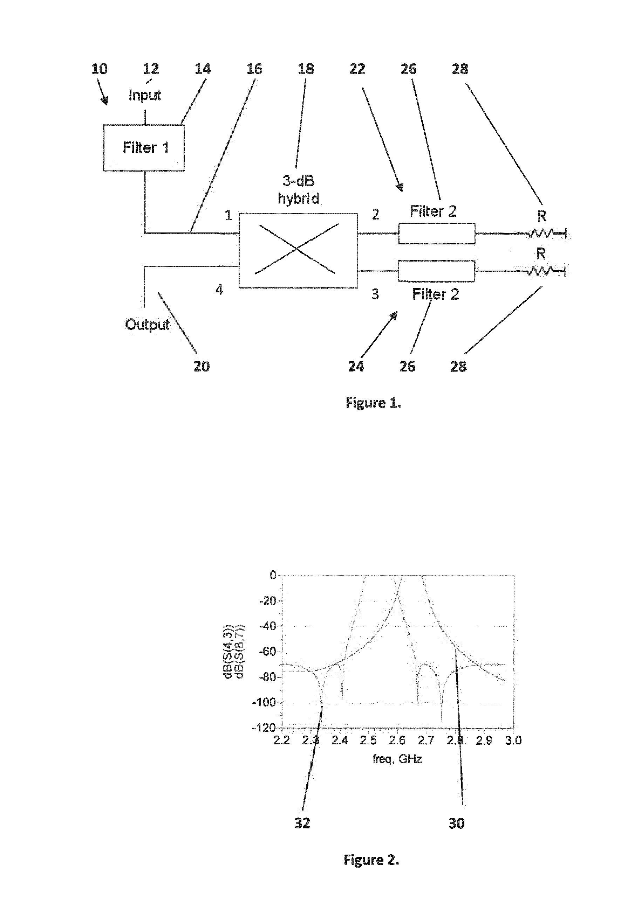

A means of introducing a transmission zero or notch into the response of a filter is disclosed in European Patent Application EP12360054.6 filed 02.08.2012 (ref. 811079) and is shown in Fig. 1. A filter assembly 10 comprises an input path 12 for an Input signal to be filtered in a first bandpass filter 14. An output path 16 from the first filter provides a filtered signal to input port 1 of a 3-dB hybrid quadrature coupler 18. An output signal is provided on the path 20 from port 4 of the coupler 18. Coupled to port 2 of the coupler is a reflective load 22, and coupled to port 3 is an identical reflective load 24. Each load 22, 24 comprises a bandpass second filter 26 (Filter 2) in series with a terminating resistive load 28 (R).

Filters 1 and 2 have their pass-bands in the vicinity of each other, so that the stop-band of Filter 1 overlaps with the pass-band of Filter 2. In this way, any RF signal existing in the stop-band of Filter 1 is greatly absorbed by Filters 2 and its power dissipated on resistors R and internal parasitic elements of Filters 2. On the other hand, the stop-bands of Filters 2 coincide with the pass-band of Filter 1; from the operational principles of 3-dB couplers, this implies that the RF signal in the pass-band of Filter 1 will not be dissipated on resistors R and internal parasitic elements of Filters 2, but instead will be reflected back to the output port 4 of the coupler. In this way high RF power does not flow through Filters 2 and smaller and less robust components can be used in making Filters 2. This configuration has two advantages, firstly that a broad transmission zero is introduced adjacent the pass-band of Filter 1, its frequency width being equal to the pass band of Filters 2, and secondly that the Filters 2 are not required to be low loss. In effect, the width and the depth of the introduced transmission zero is dependent only on the absorptive/reflective characteristic of the coupler and Filters 2. A good reflective characteristic of filters is routinely achieved and is mandatory for all filter types. This has an important implication in that it allows that the requirements on the filter assembly of Figure 1, namely low loss in the pass-band and high rejection in the stop-band to be treated separately. To be specific, the requirement for low insertion loss is achieved by an appropriate choice of Filter 1, which does not need to be of a high order and does need to satisfy the stop-band requirements; rather it needs to provide low insertion loss in the pass-band. The second requirement, namely that of high attenuation in the stop-band, is achieved by Filters 2, which need not have a low insertion loss, but they need to exhibit a good reflective characteristic. In this way, the reflection characteristic of Filters 2 becomes a transmission characteristic of Filter 1, i.e. the depth of the transmission zero is equal to the reflection coefficient of Filters 2.

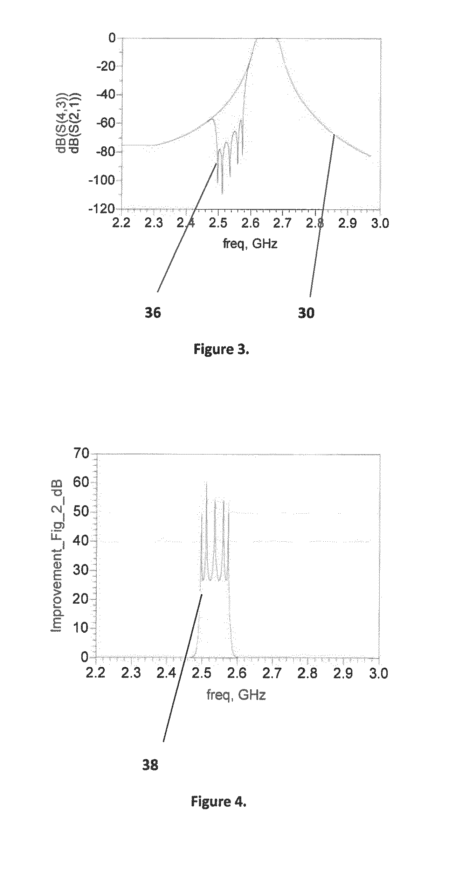

As an example, consider the responses in Fig. 2, which depicts the responses of Filter 1 (line 30) and Filters 2 (line 32) alone. For the purpose of these responses, Filter 1 is a four pole Chebyshev filter, while Filters 2 are 6 pole elliptic filters. As evident, the pass-band of each filter corresponds to the stop-band of the other. The transmission zero introduced by the filter structure of Fig. 1 is now illustrated in Fig. 3, where line 30 represents the response of Filter 1, and line 36 illustrates the transmission zero. As can be seen from Fig. 3 the transmission zero introduced by the structure of Fig. 1 is broad and has improved the stop-band performance significantly, at least by 25 dB in the stop-band region 36 of 2.52-2.57 GHz. This is shown specifically in Figure 4, line 38 indicating the improvement in the stop band attenuation.

On the downside, the improvement in the stop-band is followed by a small deterioration of the insertion loss in the pass-band, being up to 0.2 dB greater than that exhibited by Filter 1 alone. However, since the order of Filters 2 can be increased with no concern to its insertion loss performance, this deterioration can be further reduced. In either case, the great improvement in the stop-band is enough to justify this attenuation. Even though the improvement of 25 dB may be justifiable for some applications, there are situations where even greater attenuations in the stop-band are required, without further deterioration of the overall pass-band performance.

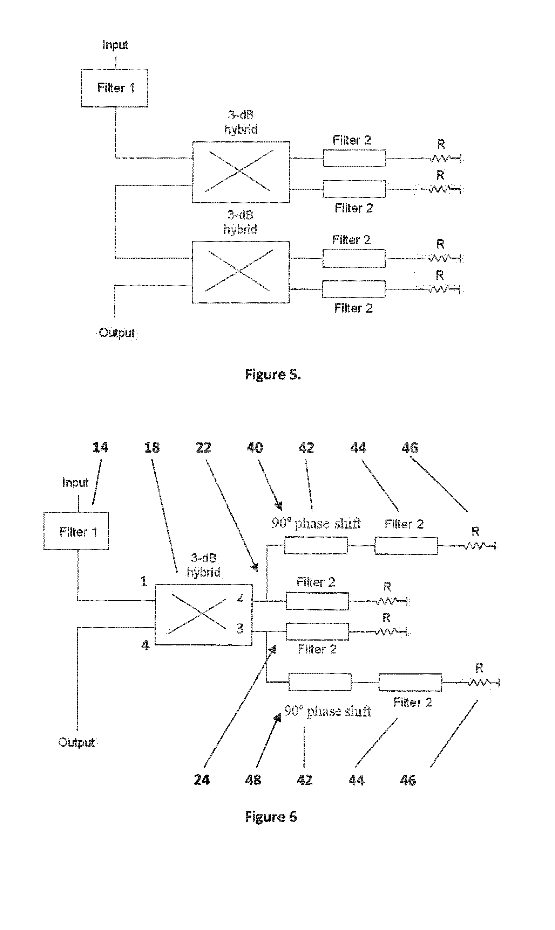

Stop-band attenuation of the filter assembly of Fig. 1 may be improved by provide a cascade connection of Filter 1 and two similar reflective filter structures comprising 3-dB couplers and Filters 2, as shown in Figure 5. However, even though this configuration will inevitably improve the performance of filter 1, it increases the complexity, the number of components needed (hence cost) and, most importantly, the insertion loss since the RF signal needs to go through an additional 3-dB coupler.

This issue is addressed by the assembly shown in Figure 6, where a single coupler 18 is provided, but two sets of Filters 2 are provided, which results in two transmission zeros superposed on one another. In Figure 6, similar parts to those of Figure 1 are denoted by the same reference numeral. Coupled to port 2 of coupler 18, in parallel with reflective load 22, is a further reflective load 40 comprising the series connection of a 90°phase shift device 42, provided by a quarter wave transmission line, a bandpass filter 44 (Filter 2) and a load impedance 46 (R). Coupled to port 3 of coupler 18, in parallel with reflective load 24, is a further reflective load 48 comprising the series connection of a 90°phase shift device 42, provided by a quarter wave transmission line, a bandpass filter 44 (Filter 2) and a load impedance 46 (R). The addition of a 90° phase shift in reflective loads 40, 48 alters the overall filter transfer characteristic, due to the fact that the parallel combination of loads 40, 48 with loads 22, 24, cannot be regarded as a simple parallel connection of a pair of loads. The parallel connection of loads 40, 48 with loads 22, 24 is equivalent to a parallel connection of a pair of loads only in the pass-band region of Filters 2, while in the rejection band of Filters 2 this equivalence ceases to exist. Due to this, loads 40, 48 provide an additional transmission zero in addition to that provided by loads 22, 24, and hence a deepening of the attenuation in the stop-band of RF filter 14. It can be proven that the electrical performance of this network in the stop-band is identical to the structure of Fig. 5.

However, due to the fact that there are two 50Ω loads connected in parallel in the pass-band region of Filters 2; the reference impedance of the 3-dB coupler needs to be 25Ω. Nevertheless, this can be avoided by either introducing 70.7Ω, λ/4 impedance transformers prior to Filters 2, or introducing 35.35Ω, λ/4 impedance transformers at the coupled and direct ports of the 3-dB coupler. A disadvantage of this method lies in the fact that it utilizes λ/4 transforming transmission line lengths, which, if the frequency of operation is low (low microwave or UHF/ VHF about 500 - 700 MHz), can be very long in relation to the circuit physical size. Transmission line lengths can be replaced by their lumped element equivalent circuits, but in this case one faces the issue of obtaining the correct transformation impedance from commercially available lumped elements.

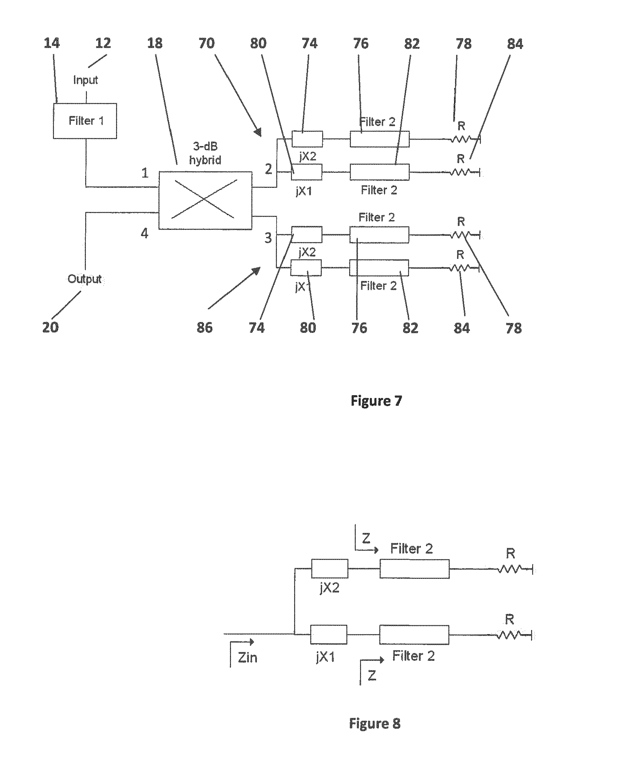

An embodiment of the invention is shown in Figures 7 and 8, wherein similar parts to those of Figure 1 are denoted by the same reference numeral. The structure of Fig. 7 contains no λ/4 transformers, instead, it utilises two lumped reactive elements per reflective load, each element providing a non-inverting impedance, and easily lending this structure to miniaturisation, which is of particular importance at lower RF frequencies (700 MHz or lower). The embodiment has a response of a double transmission zero. Referring to Figure 7, first reflective load 70 is connected to port 2 of quadrature hybrid 3dB coupler 18. Load 70 comprises a single lumped component reactance 74 (jX2) (capacitor or inductor) connected in a series path with a bandpass second filter 76 (Filter 2) and terminating load resistance 78 (R). In parallel with this series path is a further series path comprising a single lumped component reactance 80 (jX1) (capacitor or inductor) in series with a bandpass second filter 82 (Filter 2) and terminating load resistance 84 (R).

Reflective load 86, identical to load 70, is connected to port 3 of quadrature hybrid 3 dB coupler 18. Load 86 comprises a first series path comprising a single lumped component reactance 74 (jX2) (capacitor or inductor) connected in series with a bandpass second filter 76 (Filter 2) and terminating load resistance 78 (R). In parallel with the first path is a second series path comprising a single lumped component reactance 80 (jX1) (capacitor or inductor) connected in series with a bandpass second filter 82 (Filter 2) and terminating load resistance 84 (R).

The conditions which need to be imposed on the reactive elements of the structure of Fig. 7, in order to achieve a double transmission zero have to be assessed. Referring to Figure 8, which shows the reflective load 70 (or 86) of the 3-dB coupler of Fig. 7.

The input impedance, $Z_{in}$ of the total reflective load of Fig. 8 is:

$$Z_{in} = \frac{2Z^3 - 2ZX_1X_2 + (X_1 + X_2) \cdot (ZX_2 + ZX_1) + j\left[X_1X_2(X_1 + X_2) + 2Z(ZX_2 + ZX_1) - Z^2(X_1 + X_2)\right]}{4Z^2 + (X_1 + X_2)^2}$$

(1)

Where Z is the input impedance of Filter 2 in series with impedance R. This equation is derived, considering that the impedance of the two series paths of load 70 is (jX1 +Z), in parallel with (jX2 +Z), and the combined impedance of the two parallel loads is 1/[1/(jX1 +Z) + 1/(jX2 +Z)]. Equation (1) is a rationalized representation of this combined and complex impedance, separated into a real part $2Z^3 ....+ZX_1)$ ; and an imaginary part $+j[X_1X_2(.....X_2)]$.

First, it is necessary to impose the condition that the imaginary part of the input impedance is equal to zero, Im(Zin) = 0, so that the input impedance is purely real. The impedance has to be real and equal to the impedance of the 3dB coupler - 50Ω. Solving Im(Zin) = 0 yields the following relationship:

$$Z^2 = -X_1 X_2 \quad (2)$$

The input impedance can now be arranged as:

$$Z_{in} = \frac{2Z^3 + Z(X_1^2 + X_2^2)}{4Z^2 + (X_1 + X_2)^2} \quad (3)$$

The reflection coefficient of the load in Fig. 8 can now be written:

$$\Gamma = \frac{Z_{in} - Z_0}{Z_{in} + Z_0} = \frac{2Z^3 + Z^2(-4Z_0) + Z(X_1^2 + X_1^2) - Z_0(X_1 + X_2)^2}{2Z^3 + Z^2(4Z_0) + Z(X_1^2 + X_1^2) + Z_0(X_1 + X_2)^2} \quad (4)$$

Here, $Z_0$ represents the impedance in the direction of the source of the signal, i.e. the port of the 3dB coupler, that is the characteristic impedance of the inter-connecting microstrip line within the 3dB coupler and appearing at port 2 or 3 - 50Ω. The requirement that the reflection coefficient at the input of the structure of Fig. 8 is zero represents a condition for the achievement of a transmission zero. However, by substituting condition (2) into equation (4), it can be shown that the reflection coefficient becomes:

$$\Gamma = \frac{Z_{in} - Z_0}{Z_{in} + Z_0} = \frac{Z^5 + Z^4(-Z_0) + Z^3(2X_1^3) + Z^2(-2Z_0X_1^2) + Z(X_1^4) - Z_0X_1^4}{Z^5 + Z^4(Z_0) + Z^3(2X_1^3) + Z^2(2Z_0X_1^2) + Z(X_1^4) - Z_0X_1^4} \quad (5)$$

which after factorization becomes:

$$\Gamma = \frac{(Z - Z_0)\left[Z^4 + 2X_1^2 Z^2 + X_1^4\right]}{(Z + Z_0)\left[Z^4 + 2X_1^2 Z^2 + X_1^4\right]} = \frac{(Z - Z_0)}{(Z + Z_0)} \quad (6)$$

(6) represents the original representation of the reflection coefficient in (4), and implies a single zero, not a double zero as it is sought. But given the fact that the reflective load consists of two filters, the intention is to achieve a double transmission zero.

As such, it is concluded that a generic solution towards the achievement of the double zero with the circuit of Fig. 7 does not exist. This can be explained as follows. If one considers equation (4), a full polynomial of order 3 can be recognized in both the numerator and denominator. Since the circuit of Fig. 8 can provide at most two transmission zeroes, a condition regarding the values of $X_1$ and $X_2$ must be substituted into (4) in such a way as to reduce the order of the polynomials from 3 to 2.

By inspection of equation (1), and the imaginary part thereof, the imaginary part is zero if a substitution is made: $X_1 = -X_2$ and condition (2) now becomes:

$$Z^2 = X_1^2 = X_2^2 \quad (7)$$

Other substitutions may be possible, e.g. $X_1 = -X_2 + \delta$, $\delta$ being an incremental fixed amount. This would not provide an exact solution, but takes into account small differences between the calculated values for X1 and X2 and those values in the real world.

With this substitution, the full third order polynomials in (4) are now reduced to second order polynomials, i.e.:

$$\Gamma = \frac{Z^2 + Z(-2Z_0) + X_1^2}{Z^2 + Z(2Z_0) + X_1^2} \quad (8)$$

The double transmission zero is found from the condition that $\Gamma = 0$, i.e.:

$$Z_{1,2} = \frac{2Z_0 \pm \sqrt{4Z_0^2 - 4X_1^2}}{2} \quad (9)$$

The necessary condition for a double zero is achieved by requiring that the discriminant is equal to zero, which yields the value for the lumped element $X_1$, i.e. $X_1 = Z_0$. Once this condition is satisfied, a double zero is achieved at:

$$Z_{1,2} = Z_0 \quad (10)$$

And (8) can be re-written as:

$$\Gamma = \frac{(Z - Z_0)(Z - Z_0)}{(Z + Z_0)(Z + Z_0)} \quad (11)$$

In this way a double zero is achieved if the lumped elements are chosen in this fashion:

$$Z = \pm X_1 = \mp X_2 = Z_0 \quad (12)$$

i.e. the lumped elements have reactances that are of a magnitude equal to the characteristic impedance of the inter-connecting lines, but of opposite signs. For example, if $Z_0 = 50\Omega$, then:

$$\pm X_1 = \mp X_2 = 50\Omega$$

The reactances $X_1$ and $X_2$ are then simple capacitors and inductors.

Furthermore, if the double zero is not sought, the discriminant in (9) need not be set to zero, but it can be set to another value. In this way, two distinct zeros can be obtained, positioned at impedance points of interest. It has also to be borne in mind that there will be always be a difference, however minute, between the calculated values and the ones used in practice. There are many reasons for this, but the main ones are associated with the fact that real world components are fabricated with a tolerance in mind. For example, a 3-dB coupler might not be exactly 3 dB, but 3.5 dB - the extra 0.5 dB coming from the internal losses of the device. The capacitor/inductor usually has a specified tolerance to its value expressed in the form of percentage. Therefore the equations as set out above, in particular (2), (7) and (9) may be satisfied only approximately, but transmission zeros may be obtained sufficient for a particular practical situation.

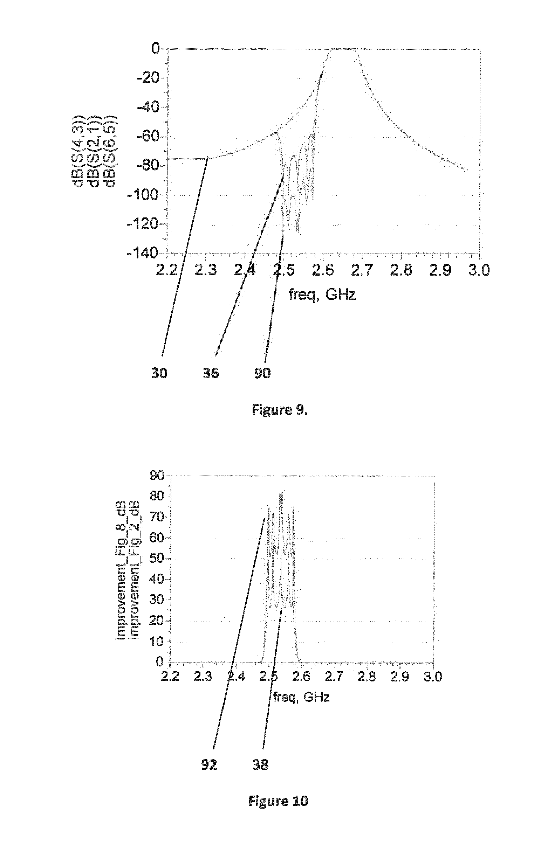

One example of this embodiment is given. Here, an example of double zero is provided, using the same filters that have been used for the results presented in Figures 2 to 4. The reactive elements X1 and X2 are realized using a capacitor and inductor, with their values L = 3.14 nH and C = 1.25 pF (their reactances are approximately equal to 50Ω at 2.5 GHz). The results are shown in Figs. 9 and 10 , where the results achieved with this embodiment as at 90, 92, are compared with the results of Figures 3 and 4 as at 36, 38, curve 30 representing the response of Filter 1. As evident from Fig.s 9 and 10, a double transmission zero is achieved and improvement of over 50 dB compared to the response of filter 1 alone are possible. However, it needs to be stated that this improvement is not obtained without a sacrifice, as the insertion loss in the pass-band has been increased by up to 0.2 dB, compared to the insertion loss obtained by the filter structure of Fig. 2. Nevertheless, such a small sacrifice is acceptable in most applications, especially in the light of the improvements of attenuation in the stop-band.

Embodiments of the invention provide a novel architecture for achieving deeper transmission zeros. Greater attenuation in the stop-band and less space occupied on a PCB are achieved.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

**Claims**

1.  An RF filter assembly including a first RF filter having a pass band and a stop band for providing a filtered RF signal, an RF reflective load means including an RF connecting device having a first input port connected to receive the filtered RF signal, a second output port to provide a further filtered RF signal, and including a third port with a reflective load connected to the third port, said reflective load including first and second series paths connected in parallel, the first series path including a first reactive element having a first predetermined reactance value, and a second filter, and the second series path including a second reactive element having a second predetermined reactance value, and a second filter, wherein said first and second predetermined reactance values have a relationship such as to provide first and second transmission zeros at frequencies such that pass bands of said second filters occur in the stop band of the first RF filter, and stop bands of said second filters occur within the pass band of the first RF filter.

2.  An RF filter according to claim 1, wherein said connecting device comprises a four port RF coupler including said first, second and third ports, and including fourth port, with a further reflective load connected to the fourth port, said further reflective load including first and second series paths connected in parallel, the first series path including a first reactive element having a first predetermined reactance value, and a second filter, and the second series path including a second reactive element having a second predetermined reactance value, and a second filter, wherein said first and second predetermined reactance values of the further reflective load have a relationship such as to provide first and second transmission zeros at frequencies such that pass bands of said second filters occur in the stop band of the first RF filter, and stop bands of said second filters occur within the pass band of the first RF filter.

3.  An RF filter according to claim 2, wherein the RF coupler comprises a 3 dB quadrature hybrid coupler.

4.  An RF filter according to any preceding claim, wherein the first and/or second reactive element each comprises a single component, inductor or capacitor.

5.  An RF filter according to any preceding claim, wherein the resultant input reactance value of the or each said reflective load at a frequency of interest is zero, or approximately zero.

6.  An RF filter according to claim 6, wherein said first and second reactive elements have equal and opposite reactance values, or approximately equal and opposite values.

7.  An RF filter according to any preceding claim, wherein the reactance values of the first and second reactive elements have predetermined values relative to the characteristic impedance of transmission lines provided which couple said third port to the reflective load.

8. An RF filter according to claim 6, wherein the magnitudes of said values is each equal, or approximately equal, to said characteristic impedance.

9. An RF filter according to any preceding claim, wherein said first and second transmission zeros are superposed on one another in terms of frequency, and said first and second reactive elements have equal and opposite values.

10. An RF filter according to any preceding claim, wherein each said series path includes a terminating resistance.

**Amended claims in accordance with Rule 137(2) EPC.**

1. An RF filter assembly including a first RF filter (14) having a pass band and a stop band for providing a filtered RF signal, an RF reflective load means including an RF connecting device (18) having a first input port connected to receive the filtered RF signal, a second output port to provide a further filtered RF signal, and including a third port with a reflective load (86) connected to the third port, said reflective load including a first series path including a first bandpass filter means (76), **characterised in that** said reflective load includes a second series path connected in parallel with said first path, the first series path including a first reactive element (74) having a first predetermined reactance value, and the second series path including a second reactive element (80) having a second predetermined reactance value of opposite sign to said first value, and a second bandpass filter means (82), wherein said first and second predetermined reactance values are selected such as to provide first and second transmission zeros (90) at frequencies such that pass bands of said bandpass filter means occur in the stop band of the first RF filter, and stop bands of said bandpass filter means occur within the pass band of the first RF filter.

2. An RF filter according to claim 1, wherein said connecting device comprises a four port RF coupler including said first, second and third ports, and including fourth port, with a further reflective load (70) connected to the fourth port, said further reflective load including first and second series paths connected in parallel, the first series path including a first reactive element (74) having a first predetermined reactance value, and a first bandpass filter means (76), and the second series path including a second reactive element (80) having a second predetermined reactance value, and a second bandpass filter means (82), wherein said first and second predetermined reactance values of the further reflective load have a relationship such as to provide first and second transmission zeros (90) at frequencies such that pass bands of said bandpass filter means occur in the stop band of the first RF filter, and stop bands of said bandpass filter means occur within the pass band of the first RF filter.

3. An RF filter according to claim 2, wherein the RF coupler comprises a 3 dB quadrature hybrid coupler.

4. An RF filter according to any preceding claim, wherein the first and/or second reactive element each comprises a single component, inductor or capacitor.

5. An RF filter according to any preceding claim, wherein the resultant input reactance value of the or each said reflective load at a predetermined frequency is zero, or approximately zero.

6. An RF filter according to any preceding claim, wherein said first and second reactive elements have equal and opposite reactance values, or approximately equal and opposite values.

7. An RF filter according to any preceding claim, wherein the reactance values of the first and second reactive elements have predetermined magnitudes equal to the impedance in the direction of the third port from said first mentioned reflective load.

8. An RF filter according to claim 6, wherein the magnitudes of said values is each equal, or approximately equal, to said characteristic impedance.

9. An RF filter according to any preceding claim, wherein said first and second transmission zeros are superposed on one another in terms of frequency, and said first and second reactive elements have equal and opposite values.

Figure 1.

Figure 2.

**36**                     **30**

Figure 3.

**38**

Figure 4.

**Figure 5.**

**Figure 6**

Figure 7

Figure 8

Figure 9.

Figure 10

Europäisches
Patentamt

European
Patent Office

Office européen
des brevets

# EUROPEAN SEARCH REPORT

Application Number

EP 13 29 0128

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/080229 A1 (KENINGTON PETER [GB]) 7 April 2011 (2011-04-07) * paragraphs [0009], [0014], [0045], [0046], [0051] - [0058]; figures 1c,2e,2g * | 1-10 | INV. H03H7/06 |
| A | JP 2007 208350 A (NIPPON DENGYO KOSAKU CO LTD; JAPAN BROADCASTING CORP) 16 August 2007 (2007-08-16) * paragraphs [0001], [0003], [0012], [0014]; figures 1,4,9,10,12-14 * | 1-10 | |
| A | LUCYSZYN S ET AL: "MMIC tunable active notch filter", ELECTRONICS LETTERS, IEE, vol. 32, no. 11, 23 May 1996 (1996-05-23), pages 980-981, XP006005169, * paragraphs [0003], [0004]; figure 1 * | 1-10 | |
| A | BAHL ET AL: "Power Dividers/Combiners and 12.1.4 Matching Networks )", LUMPED ELEMENTS FOR RF AND MICROWAVE CIRCUITS, XX, XX, June 2003 (2003-06), XP002427769, * section 12.1.4 MAtching Networks * | 1-10 | TECHNICAL FIELDS SEARCHED (IPC) H03H H01P |

The present search report has been drawn up for all claims

| Place of search | Date of completion of the search | Examiner |
|---|---|---|
| Munich | 4 November 2013 | Maget, Judith |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 13 29 0128

This annex lists the patent family members relating to the patent documents cited in the above-mentioned European search report.
The members are as contained in the European Patent Office EDP file on
The European Patent Office is in no way liable for these particulars which are merely given for the purpose of information.

04-11-2013

| Patent document cited in search report | | Publication date | Patent family member(s) | | Publication date |
|---|---|---|---|---|---|
| US 2011080229 | A1 | 07-04-2011 | NONE | | |
| JP 2007208350 | A | 16-08-2007 | JP | 4105726 B2 | 25-06-2008 |
| | | | JP | 2007208350 A | 16-08-2007 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110080856 A

- EP 12360054 A